# FASCICULE DE BREVET EUROPEEN

(11) **EP 3 961 720 B1**
(45) Date de publication et mention de la délivrance du brevet: **23.08.2023**
(21) Numéro de dépôt: 21188376.4
(22) Date de dépôt: 29.07.2021
(51) Int. Cl.: H01L 29/66, H01L 29/786, H01L 29/78, H01L 29/165

(54) **ENRICHISSEMENT GERMANIUM AUTOUR DU CANAL PAR BLOCS SURELEVES**
GERMANIUMANREICHERUNG UM DEN KANAL HERUM DURCH ERHÖHTE BLÖCKE
GERMANIUM ENRICHMENT AROUND THE CHANNEL BY RAISED BLOCKS

(30) Priorité: 31.08.2020 FR 2008831
(43) Date de publication de la demande: 02.03.2022
(73) Titulaire: Commissariat à l'énergie atomique et aux énergies alternatives, 75015 Paris (FR)
(72) Inventeur: NIEBOJEWSKI, Heimanu, 38054 Grenoble Cedex 09 (FR); PLANTIER, Christophe, 38054 Grenoble Cedex 09 (FR); REBOH, Shay, 38054 Grenoble Cedex 09 (FR)
(74) Mandataire: Brevalex

(56) Documents cités:
- EP-A1- 3 376 545
- US-A1- 2008 042 209
- US-A1- 2016 118 251
- US-A1- 2016 247 888
- MUNGI PARK ET AL: "New Graded Ge Condensation Method for Formation of Ge-on-Insulator Layer", JOURNAL OF THE KOREAN PHYSICAL SOCIETY, vol. 51, no. 3, 15 septembre 2007 (2007-09-15), page 1100, XP055513439, KR ISSN: 0374-4884, DOI: 10.3938/jkps.51.1100

## Description

### DOMAINE TECHNIQUE ET ÉTAT DE LA TECHNIQUE ANTÉRIEURE

La présente description concerne le domaine des structures de transistors, et plus particulièrement celles dotées d'une zone de canal subissant une déformation ou contrainte mécanique.

Par déformation mécanique on entend un matériau qui a son ou ses paramètre(s) de maille cristalline allongé(s) ou écourté(s).

Dans le cas où le paramètre de maille déformé est plus important que le paramètre dit « naturel » d'un matériau cristallin, celui-ci est dit en déformation en tension. Lorsque le paramètre de maille déformé est plus petit que le paramètre de maille naturel, le matériau est dit en déformation compressive ou en compression.

A ces états de déformation mécanique, on associe des états de contraintes mécaniques. Pour autant, il est également commun de se référer à ces états de déformation comme des états de contraintes mécaniques. Dans la suite de la présente demande, cette notion de déformation (« strain » selon la terminologie anglo-saxonne) sera désignée de façon générique par le terme « contrainte ».

Une contrainte appliquée à un matériau semi-conducteur induit une modification de la maille cristalline et donc de sa structure de bande, dont va découler une modification de la mobilité des porteurs dans ce matériau.

La mobilité des électrons est augmentée (respectivement diminuée) par une contrainte longitudinale en tension (respectivement en compression) du matériau semi-conducteur dans lequel ils transitent alors que la mobilité des trous sera augmentée (respectivement diminuée) lorsque le semi-conducteur est en compression (respectivement en tension) dans la direction longitudinale.

Pour améliorer les performances des transistors de type P, il est connu de prévoir une structure de canal formée dans une couche superficielle contrainte en compression d'un substrat de type semi-conducteur isolant.

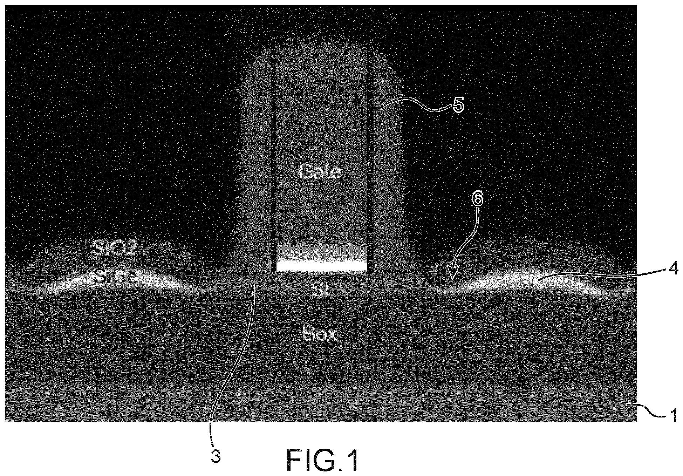

Le document US 2008/0042209 A1 présente ainsi un procédé de réalisation sur un substrat 1 SOI d'un transistor ayant une structure de canal formée dans une couche superficielle en silicium que l'on vient mettre en contrainte en compression. Cette mise en contrainte est ici réalisée par le biais d'une croissance de SiGe sur la couche superficielle puis en effectuant un enrichissement en Germanium de régions de la couche superficielle de part et d'autre de la région de canal. A l'issue de cet enrichissement en Germanium, des zones de pincement 6 où l'épaisseur de matériau semi-conducteur est réduite peuvent avoir tendance à se former de part et d'autre d'une région 3 de la couche superficielle située en regard de la grille et des espaceurs 5. De telles zones de pincement 6 entre cette région 3 et des portions 4 enrichies en Germanium sont illustrées sur la figure 1 et posent plusieurs problèmes.

Elles peuvent tout d'abord limiter voire empêcher la transmission de la contrainte vers la région de canal.

Elles peuvent également gêner la formation ultérieure de blocs de source et de drain en étant à l'origine de phénomènes de démouillage d'une épaisseur semi-conductrice que l'on réalise ensuite typiquement par épitaxie pour former ces blocs.

Elles peuvent enfin créer une discontinuité électrique de blocs de source et de drain vers le canal ou tout du moins augmenter les résistances d'accès au canal. Un autre exemple de procédé pour la fabrication d'une structure de transistor est divulgué par le document EP3376545-A1.

Il se pose le problème de trouver un nouveau procédé de réalisation d'une structure de transistor contraint et qui soit amélioré vis-à-vis d'au moins un des inconvénients énoncés ci-dessus.

### EXPOSÉ DE L'INVENTION

Un mode de réalisation de la présente invention prévoit un procédé de réalisation d'une structure de transistor, le procédé comprenant, dans cet ordre, les étapes suivantes :
- prévoir sur une région donnée d'une couche semi-conductrice superficielle d'un substrat de type semi-conducteur sur isolant, un bloc de grille et des espaceurs de part et d'autre du bloc de grille,
- faire croître sur la couche semi-conductrice superficielle des zones semi-conductrices, de sorte que les zones semi-conductrices soient agencées contre et au contact des espaceurs,
- faire croître sur lesdites zones semi-conductrices des blocs semi-conducteurs par croissance de SiₓGe₁₋ₓ avec x>0, les blocs semi-conducteurs ayant des facettes latérales réalisant un angle non-nul avec une normale à un plan principal du substrat,
- oxydation thermique de sorte à réaliser une condensation du germanium desdits blocs semi-conducteurs dans lesdites zones semi-conductrices et la couche semi-conductrice superficielle, de sorte à former des régions semi-conductrices en Si_{y}Ge_{1-y} contraintes en compression de part et d'autre des espaceurs.

Avantageusement, des cavités sont définies entre lesdites facettes (27) et lesdits espaceurs isolants (23).

Les zones semi-conductrices forment une couche tampon et permettent de mettre à distance les facettes inclinées lors de l'enrichissement en Germanium.

Cela permet ainsi d'éviter un effet intempestif de pincement dans une zone de la couche superficielle à proximité des espaceurs. On évite ainsi une discontinuité électrique ou une augmentation des résistances d'accès au canal et on permet que les régions semi-conductrices en Si_{y}Ge_{1-y} contraintes en compression de part et d'autre des espaceurs puissent servir de base à une reprise d'épitaxie.

Avantageusement, les zones semi-conductrices sont en silicium, ce matériau pouvant croître aisément sans facette.

Selon une possibilité de mise en oeuvre, on fait croître les zones semi-conductrices de sorte qu'elles soient agencées contre et au contact des espaceurs. Typiquement, la couche semi-conductrice superficielle est en Si ou en Si₁₋ₐGeₐ avec a>0.

Selon une possibilité de mise en oeuvre, les zones semi-conductrices ont une épaisseur d comprise entre 3 et 5 nm ou entre 5 nm et 25 nm.

La durée du procédé d'oxydation dépend de la concentration en Germanium desdits blocs semi-conducteurs et de la concentration désirée en Germanium pour les régions semi-conductrices en Si_{y}Ge_{1-y}. Cette durée du procédé d'oxydation dépend également de l'épaisseur d qui représente la distance d d'éloignement des blocs semi-conducteurs par rapport la couche superficielle.

Typiquement, lesdits blocs ne sont pas dopés lorsqu'on les fait croitre. Ainsi, préalablement à ladite oxydation thermique et lors de cette étape d'oxydation thermique, lesdits blocs semi-conducteurs restent sans dopage.

Typiquement, lesdites zones semi-conductrices ne sont pas dopées lorsqu'on les fait croitre. Ainsi, préalablement à ladite oxydation thermique et lors de cette étape d'oxydation thermique lesdites zones semi-conductrices restent sans dopage.

On effectue ainsi de préférence le dopage des régions de source et drain après l'enrichissement en Germanium afin d'éviter une diffusion intempestive de dopants lors de l'oxydation thermique.

Selon une possibilité de mise en oeuvre, ladite oxydation thermique conduit à la formation d'une couche d'oxyde sur lesdits blocs semi-conducteurs.

Le procédé peut alors comprendre en outre des étapes de :
- retrait de ladite couche d'oxyde, puis
- croissance d'une couche de matériau semi-conducteur sur lesdites régions semi-conductrices en Si_{y}Ge_{1-y}.

Du fait de la réalisation des régions semi-conductrices en Si_{y}Ge_{1-y} sans pincement intempestif, la croissance de matériau semi-conducteur est rendue plus aisée.

Selon un mode de réalisation particulier, après oxydation thermique, on effectue un recuit thermique sous atmosphère neutre, de sorte à homogénéiser la concentration en Germanium dans lesdites régions semi-conductrices.

### BRÈVE DESCRIPTION DES DESSINS

La présente invention sera mieux comprise sur la base de la description qui va suivre et des dessins en annexe sur lesquels :
La figure 1 sert à illustrer un phénomène de pincement intempestif de régions semi-conductrices à proximité des espaceurs suite à la mise en oeuvre d'un procédé d'enrichissement germanium tel que mis en oeuvre suivant l'art antérieur ;
Les figures 2A, 2B, 2C, 2D, 2E, 2F servent à illustrer un exemple de procédé suivant un mode de réalisation de l'invention visant à la fabrication de régions enrichies en Germanium de part et d'autre d'une région destinée à former une structure de canal de transistor ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « avant », « supérieure », « arrière », « inférieure », « latérale », s'appliquent en considérant que la structure est orientée de la façon illustrée sur les figures.

### EXPOSÉ DÉTAILLÉ DE MODES DE RÉALISATION PARTICULIERS

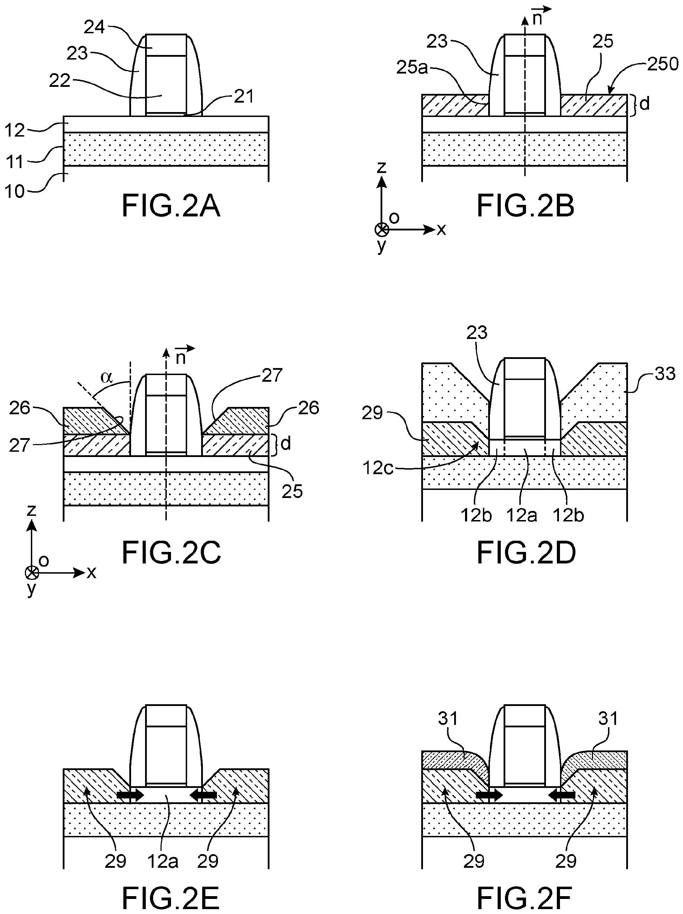

Une structure de départ possible, pour mettre en oeuvre un procédé suivant un mode de réalisation de la présente invention, est donnée sur la figure 2A.

Cette structure comprend un substrat de type semi-conducteur sur isolant, avec une couche de support 10 semi-conductrice typiquement en silicium, une couche isolante 11 d'oxyde de silicium agencée sur la couche de support 10 et une couche semi-conductrice superficielle 12 disposée sur et en contact avec la couche isolante 11. La couche semi-conductrice superficielle 12 est notamment destinée à accueillir des régions de canal de transistors.

La couche semi-conductrice superficielle 12 est à base d'un matériau semi-conducteur qui peut être en silicium dans le cas d'un substrat SOI. Dans ce cas, on utilise de préférence du silicium d'orientation <110> pour la couche semi-conductrice superficielle 12 afin d'utiliser au mieux l'effet piézo-résistif pour les trous. En variante, on peut prévoir la couche semi-conductrice superficielle 12 en Si₁₋ₐGeₐ avec a par exemple compris entre 0.05 et 0.80 et typiquement entre 0.1 et 0.6, de préférence entre 0.2 et 0.4.

Avantageusement, le substrat peut être prévu pour accueillir des transistors en technologie totalement déplétée, en particulier FDSOI (pour « Fully Depleted Silicon on Insulator » ou « silicium sur isolant totalement déplétée »). La couche semi-conductrice superficielle 12 peut être ainsi prévue avec une faible épaisseur par exemple comprise entre 3 nm et 20 nm, avantageusement entre 5 nm et 16 nm.

Dans l'exemple illustré, un diélectrique 21 de grille, un bloc 22 de grille du transistor 12, et des espaceurs 23 de part et d'autre du bloc 22 de grille sont réalisés. Le bloc 22 de grille est ici destiné à former l'électrode de grille définitive du transistor. En variante, on peut prévoir un bloc de grille factice ou sacrificiel destiné à être remplacé ultérieurement par un bloc 22 de grille définitif. Le bloc 22 de grille peut être par exemple à base de polysilicium ou de TiN ou de W ou d'un empilement de ces matériaux. Les espaceurs 23 peuvent être par exemple à base de SiN ou de SiCO ou de SiBCN ou de SiOCN.

Dans l'exemple de réalisation particulier illustré, le bloc 22 de grille est également surmonté d'un masque dur 24 par exemple formé d'une couche en SiN et/ou en SiO₂.

On fait ensuite croître par épitaxie sur la couche semi-conductrice superficielle 12 des zones 25 de matériau semi-conducteur d'une épaisseur d qui peut être comprise par exemple entre 3 et 5 nm ou entre 5 nm et 25 nm (figure 2B).

De préférence, le matériau semi-conducteur que l'on fait croître n'est pas dopé et on réalise ainsi des zones ou couches semi-conductrices 25 non-dopées à ce stade du procédé.

Le matériau semi-conducteur et/ou le procédé de croissance, sont choisis de sorte à former des zones 25 du matériau semi-conducteur sans facette latérale inclinée. Les zones 25 sont plus particulièrement formées avec des bords latéraux 25a agencés contre et en contact des espaceurs isolants 23.

Typiquement, les zones 25 sont en silicium qui croit aisément sans facette ou du Si_{1-b}Ge_{b} avec b < 0.2. Les zones 25 ont avantageusement une face supérieure 250 plane.

Pour réaliser une croissance sans facette on se place de préférence à une température « basse » qui est typiquement inférieure à 800°C, par exemple de l'ordre de 750°C ou dans des conditions telle qu'évoquées dans le document de Dutartre « Facet Propagation in Si and SiGe Epitaxy or Etching », ECS Transactions, octobre 2006.

Un exemple de procédé prévoit d'utiliser des précurseurs tels que le SiH₄ et le SiH₂Cl₂ à une température par exemple de l'ordre de 750°C pour réaliser une croissance d'une couche de Si d'épaisseur comprise par exemple entre 2 nm et 20 nm.

On fait ensuite croître par épitaxie sur les zones semi-conductrices 25, des blocs 26 d'un matériau semi-conducteur à base de Si₁₋ₓGeₓ avec x > 0, x étant typiquement prévue entre 20% et 60%, de préférence supérieure à 40%.

Un tel matériau croit en formant des facettes inclinées 27 réalisant un angle α non-nul, typiquement des facettes d'orientation (311) ou (111) réalisées sur une couche d'orientation (001) avec une normale n à un plan principal du substrat (i.e. un plan passant par le substrat et parallèle au plan [O ; x ; y ] du repère orthogonal [O ; x ; y ; z ] donné sur la figure 2C). Dans un cas où les zones semi-conductrices 25 sur lesquelles on fait croître les blocs 26 en Si₁₋ₓGeₓ, sont-elles mêmes en Si_{1-b}Ge_{b}, on prévoit un écart de concentration x-b typiquement supérieure à 10%.

L'épaisseur crue de Si₁₋ₓGeₓ peut être comprise par exemple entre 4 nm et 50 nm en utilisant des précurseurs de type SiH₂Cl₂ + GeH₄ + HCl à une température par exemple de l'ordre de 700°C.

On vient ensuite réaliser un enrichissement en Germanium des zones du matériau semi-conducteur 25 et de la couche semi-conductrice superficielle 12 par le Germanium contenu dans les blocs 26.

Un tel enrichissement est typiquement effectué à l'aide d'un procédé d'oxydation, par exemple à l'aide d'une méthode telle que décrite dans le document : « A novel fabrication technique of ultrathin and relaxed SiGe buffer layers with high Ge fraction for sub-100 nm strained silicon on insulator MOSFETs, Tezuka et al., Japanese Journal of Applied Physics, vol. 40, p 2866-2874, 2001 » ou dans le document « Selectively formed high mobility SiGe on Insulator pMOSFETs with Ge-rich strained surface channels using local condensation technique, Tezuka et al., Symposium on VLSI Technology, 2004 ».

L'oxydation thermique est réalisée de préférence à une température haute mais inférieure à la température de fusion du matériau Si₁₋ₓGeₓ. Typiquement, cette oxydation thermique est effectuée à une température comprise entre 750°C et 1100°C.

Par exemple, lorsque la couche de premier matériau semi-conducteur 25 a une épaisseur de l'ordre de 6 nm, on peut prévoir de réaliser l'oxydation à une température de 1050°C, pendant une durée de l'ordre de 20 secondes.

Durant l'étape d'oxydation, le silicium des blocs 26 a tendance à se consommer, de manière à former du SiO₂. Les régions 25 situées sous les blocs 26 ayant tendance à voir leur concentration en Germanium augmenter, ainsi que des portions de la couche superficielle 12.

Le fait de former les zones 25 semi-conductrices d'épaisseur d avant de faire croître les blocs 26, permet d'éloigner les facettes latérales 27 inclinées à une distance d déterminée et choisie du pied des espaceurs 23 et de la couche superficielle 12. La durée du procédé d'oxydation est prévue en fonction de l'épaisseur d des zones 25 semi-conductrices, sachant que ce procédé d'oxydation est de préférence prévu à température donnée, selon une durée suffisante pour permettre de consommer entièrement le matériau des blocs 26 et réaliser un enrichissement maximal avec le Germanium contenu dans ces blocs 26. La durée d'oxydation dépend également de la concentration en Germanium des blocs 26 ainsi que de la concentration finale en Germanium visée à l'issue de l'enrichissement.

En mettant les blocs 26 à facettes 27 inclinées à distance de la couche semi-conductrice superficielle 12, cela permet de réaliser un enrichissement en Germanium de la couche semi-conductrice superficielle 12 sans provoquer de rétrécissement ou tout au moins en limitant un éventuel rétrécissement au niveau d'une zone 12c qui se trouve en contact avec les régions d'accès 12b au canal 12a de la couche semi-conductrice superficielle 12.

On évite ainsi un effet de pincement tel qu'évoqué précédemment et illustré sur la figure 1, dans une zone disposée contre des régions de la couche semi-conductrice superficielle située contre les espaceurs. On limite de cette manière les risques de discontinuité de la couche semi-conductrice superficielle 12 ou tout du moins d'augmentation des résistances d'accès au canal.

De manière optionnelle, on peut ensuite réaliser au moins une étape de traitement thermique supplémentaire, cette fois de préférence sous atmosphère neutre, afin d'homogénéiser la concentration en Germanium de régions semi-conductrices 29 en silicium germanium réalisées de part et d'autre des espaceurs 23 et des régions d'accès 12b au canal 12a (figure 2D). Un tel recuit peut être effectué sous atmosphère de N₂ à une température comprise par exemple entre 800°C et 1000°C et selon une durée comprise par exemple entre 30 min et 2 heures. Par exemple, un recuit à une température de l'ordre de 900°C pendant une durée de l'ordre de 1 heure peut être effectué pour réaliser cette homogénéisation.

Une désoxydation afin de retirer une épaisseur d'oxyde 33 formée lors de la condensation en Germanium peut être ensuite réalisée. On peut ensuite effectuer ce retrait par exemple à l'aide de HF dilué, avec une teneur par exemple de l'ordre de 1%.

Les régions semi-conductrices 29 en Si_{y}Ge_{1-y} permettent d'exercer une contrainte en compression sur le canal 12a prévu dans un matériau de paramètre de maille différent (figure 2E).

On peut ensuite poursuivre la fabrication d'un transistor et de préférence un transistor de type P.

Pour compléter la réalisation de source et de drain du transistor, on peut en particulier faire croître par épitaxie une couche semi-conductrice 31 de part et d'autre des espaceurs 23 sur les régions 29 en silicium Germanium.

De préférence, on choisit un matériau semi-conducteur susceptible de favoriser une contrainte en compression dans la structure de canal. Typiquement la couche semi-conductrice 31 est en Silicium Germanium, de préférence dopé, par exemple au Bore (SiGe :B). Un dopage *in situ* effectué pendant la croissance du matériau semi-conducteur peut être ainsi effectué. Une dose par exemple de l'ordre de 1^{e}20 at^{∗}cm⁻³ peut être par exemple employée. Le dopage de la source et de drain peut, en variante ou en complément du dopage *in situ,* comprendre une étape d'implantation.

Un recuit d'activation des dopants peut être mis en oeuvre par la suite.

On peut également réaliser des contacts sur la source, le drain et éventuellement sur la grille par formation de zones de composé de métal et de sur ces régions.

D'autres étapes de fabrication conventionnelles de formation d'une encapsulation isolante et de fabrication de plots de contact peuvent être ensuite effectuées.

Un transistor de type P formé dans la couche semi-conductrice superficielle enrichie en Germanium d'un substrat de type semi-conducteur sur isolant s'adapte tout particulièrement à la mise en oeuvre de circuits ayant à faible consommation (« Low Power »).

## Revendications

1. Procédé de réalisation d'une structure de transistor, le procédé comprenant, dans cet ordre, les étapes suivantes :
- fournir un bloc (22) de grille et un ou plusieurs espaceurs (23) de part et d'autre du bloc de grille sur une région donnée d'une couche semi-conductrice superficielle (12) d'un substrat de type semi-conducteur sur isolant,
- faire croître sur la couche semi-conductrice superficielle (12) des zones semi-conductrices (25), les zones semi-conductrices (25) étant en silicium et agencées contre et en contact des espaceurs (23),
- faire croître sur lesdites zones semi-conductrices (25) des blocs semi-conducteurs (26) par croissance de SixGe1-x avec x>0, les blocs semi-conducteurs ayant des facettes latérales (27) réalisant un angle non-nul avec une normale à un plan principal du substrat, des cavités étant définies entre lesdites facettes (27) et lesdits espaceurs isolants (23),
- oxydation thermique de sorte à réaliser une condensation du germanium desdits blocs semi-conducteurs (26) dans lesdites zones semi-conductrices (25) et la couche semi-conductrice superficielle (12), de sorte à former des régions semi-conductrices (29) en SiyGe1-y contraintes en compression de part et d'autre des espaceurs (23), lesdits blocs (26) et lesdites zones semi-conductrices (25) n'étant pas dopées préalablement à ladite oxydation thermique.

2. Procédé selon la revendication 1, dans lequel ladite couche semi-conductrice superficielle (12) est en Si ou en Si1-aGea avec a > 0.

3. Procédé selon l'une des revendications 1 ou 2, les zones semi-conductrices (25) ayant une épaisseur d comprise entre 5 nm et 25 nm.

4. Procédé selon l'une des revendications 1 à 3, dans lequel ladite oxydation thermique conduit à la formation d'une couche d'oxyde (33) sur lesdits blocs semi-conducteurs (26), le procédé comprenant en outre des étapes de :
- retrait de ladite couche d'oxyde, puis
- croissance de matériau semi-conducteur sur lesdites régions semi-conductrices (29).

5. Procédé selon la revendication 4, dans lequel après ladite oxydation thermique, on effectue un recuit thermique sous atmosphère neutre, de sorte à homogénéiser la concentration en Germanium dans lesdites régions semi-conductrices (29).

6. Procédé de fabrication d'un transistor de type P comprenant la réalisation d'un procédé selon l'une des revendications 1 à 5.

## Patentansprüche

1. Verfahren zur Herstellung einer Transistorstruktur, wobei das Verfahren die folgenden Schritte in dieser Reihenfolge umfasst:
- Bereitstellen eines Gitterblocks (22) und eines oder mehrerer Spacer (23) beiderseits des Gitterblocks auf einer bestimmten Region einer oberflächlichen halbleitenden Schicht (12) eines Substrats vom Typ Halbleiter auf Isolation,
- Züchten, auf der oberflächlichen halbleitenden Schicht (12), halbleitender Zonen (25), wobei die halbleitenden Zonen (25) aus Silicium sind und an und im Kontakt mit den Spacern (23) eingerichtet sind,
- Züchten, auf den halbleitenden Zonen (25), halbleitender Blöcke (26) durch Wachstum von SixGe1-x mit x > 0, wobei die halbleitenden Blöcke seitliche Facetten (27) haben, die einen Winkel ungleich null mit einer Normalen auf einer Hauptebene des Substrats bilden, wobei zwischen den Facetten (27) und den isolierenden Spacern (23) Hohlräume definiert sind,
- thermische Oxidation derart, dass eine Kondensation des Germaniums der halbleitenden Blöcke (26) in den halbleitenden Zonen (25) und der oberflächlichen halbleitenden Schicht (12) derart durchgeführt wird, dass kompressionsbeanspruchte halbleitende Regionen (29) aus SiyGe1-y beiderseits der Spacer (23) gebildet werden, wobei die Blöcke (26) und die halbleitenden Zonen (25) vor der thermischen Oxidation nicht dotiert wurden.

2. Verfahren nach Anspruch 1, wobei die oberflächliche halbleitende Schicht (12) aus Si oder aus Si1-aGea mit a > 0 ist.

3. Verfahren nach einem der Ansprüche 1 oder 2, wobei die halbleitenden Zonen (25) eine Dicke d zwischen 5 nm und 25 nm haben.

4. Verfahren nach einem der Ansprüche 1 bis 3, wobei die thermische Oxidation zur Bildung einer Oxidschicht (33) auf den halbleitenden Blöcken (26) führt, wobei das Verfahren ferner folgende Schritte umfasst:
- Entfernen der Oxidschicht, dann
- Wachsen von Halbleitermaterial auf den halbleitenden Regionen (29).

5. Verfahren nach Anspruch 4, wobei nach der thermischen Oxidation ein thermisches Tempern in neutraler Atmosphäre derart durchgeführt wird, dass die Germaniumkonzentration in den halbleitenden Regionen (29) homogenisiert wird.

6. Verfahren zur Herstellung eines Transistors vom Typ P, umfassend die Durchführung eines Verfahrens nach einem der Ansprüche 1 bis 5.

## Claims

1. A method for producing a transistor structure, the method comprising, in this order, the following steps:
- providing a gate block (22) and one or more spacers (23) on either side of the gate block on a given region of a surface semiconductor layer (12) of a semiconductor-on-insulator type substrate,
- growing on the surface semiconductor layer (12) semiconductor areas (25), the semiconductor areas (25) being made of silicon and arranged against and in contact with the spacers (23),
- growing on said semiconductor areas (25) semiconductor blocks (26) by growth of SixGe1-x with x>0, the semiconductor blocks having lateral facets (27) forming a non-zero angle with a normal to a main plane of the substrate, cavities being defined between said facets (27) and said insulating spacers (23),
- thermal oxidation so as to condense the germanium of said semiconductor blocks (26) in said semiconductor areas (25) and the surface semiconductor layer (12), so as to form SiyGe1-y semiconductor regions (29) compressively stressed on either side of the spacers (23), said blocks (26) and said semiconductor areas (25) not being doped prior to said thermal oxidation.

2. The method according to claim 1, wherein said surface semiconductor layer (12) is made of Si or Si1-aGea with a > 0.

3. The method according to one of claims 1 or 2, the semiconductor areas (25) having a thickness d comprised between 5 nm and 25 nm.

4. The method according to one of claims 1 to 3, wherein said thermal oxidation leads to the formation of an oxide layer (33) on said semiconductor blocks (26), the method further comprising the steps of:
- removing said oxide layer, then
- growing semiconductor material on said semiconductor regions (29).

5. The method according to claim 4, wherein after said thermal oxidation, thermal annealing is carried out in a neutral atmosphere, so as to homogenise the Germanium concentration in said semiconductor regions (29).

6. A method for manufacturing a P-type transistor comprising carrying out a method according to one of claims 1 to 5.
